# EUROPEAN PATENT APPLICATION

(11) **EP 2 337 089 A2**
(43) Date of publication of application: **22.06.2011**
(21) Application number: 10195561.5
(22) Date of filing: 17.12.2010
(51) Int. Cl.: H01L 31/18

(54) **Improved method of texturing semiconductor substrates**

(30) Priority: 17.12.2009 US 284375 P
(71) Applicant: Rohm and Haas Electronic Materials LLC, Marlborough, MA 01752 (US)
(72) Inventor: Barr, Robert K, Shrewsbury, MA 01545 (US); O'Connor, Corey, Worcester, MA 01605 (US)
(74) Representative: Buckley, Guy Julian

(57) **Abstract**

Semiconductor substrates are cleaned and subsequently oxidized. After the semiconductor is oxidized it is textured to reduce incident light reflectance. The textured semiconductors can be used in the manufacture of photovoltaic devices.

## Description

This application claims the benefit of priority under 35 U.S.C. §119(e) to U.S. Provisional Application No. 61/284,375, filed December 17, 2009, the entire contents of which application are incorporated herein by reference.

The present invention is directed to an improved method of texturing semiconductor substrates to reduce reflectance of incident light. More specifically, the present invention is directed to an improved method of texturing semiconductor substrates to reduce reflectance of incident light by oxidizing the semiconductor substrate with alkaline solutions after cleaning and prior to texturing the semiconductor substrate.

In general, semiconductor substrates may be fabricated by the following steps:
(1) a semiconductor ingot is cut with an inner diameter saw to obtain a wafer shaped substrate;
(2) the wafer is washed with water to remove contaminants; and
(3) the wafer is then cleaned to remove any additional contaminants not removed with the water wash, such as heavy metals, particles and organics and then the wafer is dried.

During the cutting process metal from the saw such as iron, iron oxide, copper, copper oxide and zinc contaminate the surface of the sliced semiconductor. Metals such as iron and copper are difficult to remove, in particular iron. If iron is not removed from the wafer, iron oxide, as indicated by black spots, forms on the wafer. The iron oxide may compromise the performance of the wafer in any article or device where it is used. For example, if the wafer is used in a photovoltaic device, such as a solar cell, the iron oxide may reduce incident light absorbance of the wafer, thus compromising the optimum performance of the device. In addition, slurries applied to the saw during cutting also contaminate the semiconductor. Cutting semiconductor ingots using a slurry that is either a mixture of free abrasive particles, such as silicon carbide, and an organic material or oil base such as a mineral oil, or a mixture of free abrasive particles and an aqueous solution base such as polyethylene glycol, improve the cutting process by reducing residual processing distortion, suppress process stress and suppress cutting heat. Further, by the addition of alkaline hydroxides to such slurries, process stress (residual distortion) produced by cutting is eliminated providing low-distortion wafers. Such abrasive particles and organic materials contaminate the semiconductor wafer. If the contaminants are not removed, they may compromise subsequent processing steps and the quality of the final article. Accordingly, their removal is important.

Various types of cleaning formulations are used in the semiconductor industry to clean contaminants from the wafers. In general they fall into three categories: alkaline, acid and neutral. Neutral cleaners are typically undesirable since they do not effectively clean wafers of contaminants such as burnt on cutting fluids and residual metals because they do not etch the wafer. Removal of such contaminants is critical to achieve the desired performance of many devices which include the wafer. Accordingly, alkaline and acidic cleaners are preferred because of their etching ability. While the exact components and amounts of the components in the alkaline and acid cleaners may vary, in general, alkaline cleaners include as their main component one or more alkaline hydroxides and the acid cleaners include as their main component one or more inorganic acids. Hydrofluoric acid is one of the most commonly used acids.

In addition to removing cutting fluids and residual metals, the alkaline and acid cleaners typically remove native oxide (SiO₂) from the surface of silicon containing wafers. Native oxide is formed on the wafer surfaces when they are exposed to the atmosphere. Typically it may take five days or more for the native oxide to form on silicon wafers. If the wafers are packaged in a stack or vacuum packaged, native oxide formation may take a month or more to form. This native oxide may or may not be desirable on the wafer surface. In the manufacture of semiconductors where electrodes, such as sources or drains are included, the presence of native oxide prevents the normal functioning of the electrodes. The native oxide may be removed using a solution ofhydrogen fluoride and methanol as disclosed in U.S. 5,571,375. Alternatively, native oxide may be desired for forming passivation layers in solar cell manufacture to reduce incident light reflectance as disclosed in published patent application WO2008/039067. The published patent application discloses a method of first removing the native oxide layer which has a thickness of 0.5 nanometers with a solution of hydrofluoric acid. Native oxide films of 0.5 nanometers are unsuitable for passivation purposes. After removal of the native oxide layer, a new silicon oxide layer having a thickness of 0.5-10 nanometers is grown by soaking the wafer substrate in a solution which includes one or more of nitric acid, hydrogen peroxide, sulfuric acid, hydrochloric acid, ozone, boiling water and ammonium hydride at temperatures of from room temperature to under 150° C. The passivated layer is then coated with a dielectric coating of hydrogen, silicon nitride, amorphous silicon carbide or combinations thereof. The passivation layer in combination with the dielectric layer allegedly reduces incident light reflectance of the solar cell.

The preferred method in the semiconductor industry for reducing incident light in the manufacture of photovoltaics, such as solar cells; however, is texturing or formation of pyramid structures on the surface of the semiconductor wafer. A textured semiconductor wafer surface reduces reflection across wide bands of incident light thereby increasing absorbed light intensity. Texturing methods, however, are not without problems. Known techniques for wet chemical pyramidal (tetragonal) structure texturing of (100)-orientated silicon surfaces use alkaline media, such as solutions of alkali hydroxides, alkali carbonates, ammonia or choline. Such alkali hydroxides by themselves produce unevenly textured surfaces which result in areas of high reflectivity. An additive is necessary to control the texturing rate and to form repeatable pyramid structures. Solutions of hydrazine or ethylene diamine or pyrocatechol can also be used but they are disadvantageous on account of their toxicity to workers. The most common formulations include water, sodium or potassium hydroxide and alcohol. The alcohol component used may be either ethylene glycol or isopropanol.

U.S. 3,998,659 discloses a wet texturing method based on isopropanol (IPA). This texturing solution can be used with and without silicate. In general, such texturing is done at temperatures of around 80° C for periods of 10 minutes to 30 minutes. This results in a high rate of evaporation of IPA because of IPA's boiling point of 82° C. IPA is also very volatile having a flash point of 12° C. This results in problems with regard to uniform texturing and reproducibility of the pyramidal structures as well as an enormous consumption of IPA. Non-uniform texturing of a semiconductor substrate results in increased incident light reflectance. Reproducibility is important to reduce the probability of defective products and provide reliable and efficient manufacturing, thus reducing costs to both consumers and manufacturers. The high consumption of IPA also adds to the high manufacturing costs and in high waste disposal costs for the spent chemicals. Also, in general, such IPA systems tend to have reflectance of 14% to 27% in the incident light wavelength range of 360nm to 750nm. Ideally, reflectance in this wavelength range is 13% to 14%.

Accordingly, although there are methods of texturing the surface of a semiconductor wafer to form pyramid structures, there is still a need for an improved method of forming the pyramid structures.

Methods include: a) cleaning a semiconductor substrate with an alkaline or acid silicon etching solution; b) oxidizing a surface of the cleaned semiconductor substrate with an oxidizing composition including one or more oxidizing agents, the pH of the oxidizing composition is greater than 7; and c) texturing the oxidized semiconductor substrate with a texturing composition.

The acid or alkaline cleaning solution removes unwanted contaminants, such as iron, iron oxide, copper, copper oxide and zinc deposited on the semiconductor from the saw used to cut the semiconductor substrate from an ingot. Abrasive particles, such as silicon carbide, and organic materials, such as mineral oil, and polyethylene glycol from the cutting fluid are also removed. The etching action of the alkaline or acid cleaning solution removes substantially all of the contaminants on the semiconductor. The etching action of the alkaline or acid cleaning solution also removes native oxide (SiO₂) from the semiconductor substrate.

It has been discovered that cleaning the semiconductor substrate with either alkaline or acid solutions which etch silicon containing substrates causes defects in texturing subsequent to the cleaning due to native oxide removal. This is typical of monocrystalline, multicrystalline and amorphous semiconductor substrates. In the case of monocrystalline semiconductor substrates, texturing is non-uniform and pyramid reproducibility is poor. In addition the pyramid structures tend to have smaller peaks than pyramids formed when native oxide is present. This reduces the anti-reflective performance of the semiconductor substrate. When texturing is done, the contact angle (monitored by water contact angles, e.g. ASTM method ASTM D7334-08) is desirably zero to achieve uniform texturing and, in the case of monocrystaline semiconductor substrates, pyramid reproducibility as well as pyramid structures having peaks of substantially medium heights. Native oxide removal results in contact angles of typically 50 degrees and greater for many semiconductor substrates whether monocrystalline, multicrystalline or amorphous and texturing may be reduced by 30% to 40% with an increase of incident light reflectance by as much as 30%. When hydrofluoric acid is used to clean the semiconductor substrate, contact angles may be 60 degrees and greater with texturing reduced by greater than 30%. Also, reflectance is increased by typically 10% and, in the case of monocrystalline semiconductor substrates, small peaks or micro-peaks are formed. In addition handling of the semiconductor substrates by workers between the steps of cleaning and texturing also may result in texturing defects which further reduce the anti-reflective performance of the semiconductor.

By restoring the native oxide by oxidizing the cleaned semiconductor substrate with an oxidizing composition with a pH greater than 7, the texturing defects caused by cleaning with alkaline or acid silicon etching solutions is reduced or prevented and the damage caused by any handling by workers is reversed. The contact angle is restored to substantially zero and texturing is improved. The texturing is uniform and pyramid formation on monocrystalline substrates is reproducible and pyramid heights tend to be greater than pyramids formed on semiconductor substrates without native oxide. Because the oxidizing step reforms the native oxide, various types of alkaline and acid cleaners may be used, including many conventional alkaline and acid cleaners, without compromising texturing performance. Restoring the native oxide improves the overall performance of many texturing compositions.

The methods may be used to texture semiconductors for photovoltaic devices in general, including semiconductors in the manufacture of solar cells. The method also may be used to texture semiconductors in the manufacture of optical and electrochemical detectors/sensors, biodetectors/biosensors, catalysts, ohmic contacts, interconnection lines, Schottky barrier diode contacts, optoelectronic components and other articles where reducing the reflectance of incident light improves the efficiency of the device.
Figure 1 is a 5000X SEM of a textured surface of a monocrystalline silicon wafer showing damaged pyramid structures caused by handling of the wafer by workers.
Figure 2 is a 5000X SEM of the monocrystalline silicon wafer illustrated in Figure 1 after texturing was re-done subsequent to the application of an oxidizing composition to the damaged wafer.
Figure 3 is a 5000X SEM of a monocrystalline silicon wafer showing pyramid structures formed after the native oxide was reformed using an acidic oxidizing composition.
Figure 4 is a 5000X SEM of a monocrystalline silicon wafer showing pyramid structures formed after the native oxide was reformed using an alkaline oxidizing composition.

As used throughout this specification, the indefinite articles "a" and "an" are intended to include both the singular and the plural. The term "flash point" means the lowest temperature at which the vapor of a combustible liquid can be ignited in air. The term "contact angle" means the angle of a drop of water contacting a surface of a substrate, such as a semiconductor wafer. The following abbreviations have the following meanings unless the context clearly indicates otherwise: °C = degrees Celsius; g = grams; ppm = parts per million; ppb = parts per billion; mL = milliliter; L = liter; µm = microns; nm = nanometers; A = angstrom = 1x10⁻⁴µm; bv = by volume; min. = minutes; SEM = scanning electron micrograph. All percentages and ratios are by weight unless otherwise indicated. All ranges are inclusive and combinable in any order except where it is logical that such numerical ranges are constrained to add up to 100%.

Semiconductor substrates are typically in the form of wafers. Semiconductor wafers may be crystalline or amorphous silicon. The crystalline type may be monocrystalline or polycrystalline. The wafers may be cut from ingots using any conventional method known in the art. In general, ingots are cut using conventional wire saw apparatus. An example of such a wire saw apparatus is disclosed and illustrated in U.S. 6,568,384. The wire used in the saw is such that abrasive particles such as carborundum, diamond, silicon carbide or other abrasive particles having a size of #100 to #6000 adhere to it. A bonding agent may be applied to the wire to cause the abrasives to adhere to it.

Slurries used in the cutting process are a mixture of free abrasive particles and an oil base or aqueous solution base. The oil base used is a mineral oil in which a dispersant and thickener have been mixed. The aqueous solution base used includes various additives added to 30% to 80% water or polyethylene glycol. Silicon carbide, green silicon carbide or various metal and oxide grits may be used as the free abrasive particles. Typically silicon carbide having particles sizes of #600 to #1000 is used.

The specific formulations and amounts of components in slurries may vary as determined by preferences of workers. Typically, the slurry is a mixture of a solution of mineral oil as the base to which silicon carbide is added. The mixture ratio may range from base:silicon carbide = 1:1 to 1:1.3. An aqueous base slurry may include silicon carbide added to 30% to 80% water or polyethylene glycol in a mixture of base:silicon carbide of 0.8 to 0.9:1.

The process of cutting the ingot to form a semiconductor wafer results in many contaminants on the surface of the wafer. Metals from the wire saw such as iron, iron oxide, copper, copper oxide and zinc as well as the organic materials, such as mineral oil and polyethylene glycol and abrasive particles as well as other additives which are conventionally included in slurries coat the surfaces of the wafer. Prior to any further processing steps the semiconductor wafer is cleaned and micro-etched using an aqueous alkaline or aqueous acid cleaning composition. "Micro-etching" means that silicon is removed from the wafer and an irregular surface roughness of 0.025 µm to 2µm (peak-to-valley height). Native oxide (SiO₂) is also removed in micro-etching as well as encrusted residues.

Aqueous alkaline cleaning compositions which etch silicon may include, but are not limited to, one or more alkaline hydroxides, such as sodium hydroxide and potassium hydroxide, ammonium hydroxide and one or more quaternary ammonium hydroxides. Such hydroxides are typically included in amounts of from 0.01wt% to 15wt% of the cleaning composition. Acid cleaners which etch silicon may include, but are not limited to, one or more inorganic acids, such as hydrochloric acid, sulfuric acid, nitric acid and hydrofluoric acid. Such inorganic acids are included in amounts of 0.5wt% to 10wt%. One or more surfactants may be included in the alkaline and acid cleaning compositions. Conventional surfactants which are used in cleaning compositions may be used. Typically nonionic surfactants are included in the alkaline and acid cleaning compositions. They may be included in conventional amounts. Additives such as chelating agents, alcohols, polyols, such as glycols also may be included. They may be included in conventional amounts.

The aqueous alkaline and acid cleaning solutions may be applied to the semiconductor wafer immediately after the cutting process by any suitable method known in the art. The semiconductor wafer may be immersed in the cleaning solutions, the solutions may be sprayed on the semiconductor wafer or the solutions may be used in conventional ultrasonic cleaning processes. The pH of the aqueous alkaline cleaning solutions range from 11 and higher, typically 12 to 13. The acid cleaning solutions range in pH from 6 and lower, typically 1 to 4. The aqueous alkaline and acid cleaning solutions may be applied at temperature ranges from 30° C to 90° C, typically from 45° C to 60° C. The cleaning solutions are applied to a surface of the semiconductor substrate over various dwell times, typically the dwell times range from 1 min. to 40 min., more typically from 5 min. to 30 min. The semiconductor substrate is then optionally rinsed with water.

Typically the cleaning solution is an alkaline composition. More typically the alkaline cleaning solution is an aqueous alkaline composition including one or more quaternary ammonium hydroxides; one or more alkaline hydroxides and one or more mid-range alkoxylates. The weight ratio of quaternary ammonium hydroxide to alkali metal hydroxide ranges from 2:1 to 1:2, typically 1.5:1 to 1:1.5, more typically 1.25:1 to 1:1.25, most typically 1:1. Quaternary ammonium hydroxides include, but are not limited to, tetramethyl ammonium hydroxide (TMAH), tetraethyl ammonium hydroxide, tetrapropyl ammonium hydroxide, tetrabutyl ammonium hydroxide, tetramethyl-2-hydroxylethyl ammonium hydroxide (choline), trimethyl-3-hydroxypropyl ammonium hydroxide, trimethyl-3-hydroxybutyl ammonium hydroxide, trimethyl-4-hydroxybutyl ammonium hydroxide, tritriethyl-2-hydroxylethyl ammonium hydroxide, tripropyl-2-hydroxyethyl ammonium hydroxide, tributyl-2-hydroxylethyl ammonium hydroxide, dimethylethyl-2-hydroxyethyl ammonium hydroxide, dimethyldi(2-hydroxyethyl ammonium hydroxide, monomethyltri(2-hydroxyethyl) ammonium hydroxide, monomethyltriethyl ammonium hydroxide, monomethyltripropyl ammonium hydroxide, monomethyltributyl ammonium hydroxide, monoethyltrimethyl ammonium hydroxide, monoethyltributyl ammonium hydroxide, dimethyldiethyl ammonium hydroxide and dimethyldibutyl ammonium hydroxide. Quaternary ammonium hydroxides are included in amounts of 0.01wt% to 15wt% of the aqueous cleaning composition. Typically, the quaternary ammonium hydroxides are included in amounts of 1wt% to 10wet%.

Alkali metal hydroxides include potassium, sodium hydroxide and lithium hydroxide. Typically sodium hydroxide and potassium hydroxide are used. More typically, potassium hydroxide is used. Such alkali metal hydroxides are included in amounts of 0.01wt% to 10wt% of the aqueous cleaning and micro-etching composition. Typically, the alkali metal hydroxides are included in amounts of 0.5wt% to 8wt%.

Nonionic mid-range alkoxylate surfactants provide dynamic wetting of the semiconductor surface and are also low foaming. Dynamic wetting means that the surfactants displace another liquid or air from the surface of the semiconductor wafer. This enables rapid and efficient removal of many contaminants adhering to the wafer surface. In addition the nonionic mid-range alkoxylate surfactants are bio-degradable thus they are environmentally friendly. In one embodiment mid-range alkoxylate non-ionic surfactants include compounds having a general formula:

R¹-O-[(CH₂CH(R²)-O)ₓ(CH₂CH₂O)_{y}]_{z}-H (I)

wherein x is independently at each occurrence, 0 or a real number from 1 to 11, provided that, in at least one occurrence, x is greater than 0; y is, independently at each occurrence, 0, or a real number from 1 to 20, provided that, in at least one occurrence, y is greater than 0; z is a whole number from 1 to 50; R¹ is a C₆₋₁₀ branched or linear alcohol; and R² is, independently at each occurrence, -CH₃ or -CH₂CH₃.

It is understood that "x" and "y" represent average degrees of, respectively, propoxylation or butoxylation, depending on the identity of R², and ethoxylation. Thus, x and y need not be whole numbers. Taken together, x and y establish a degree of alkoxylation in an oligomer distribution. It is apparent that the order of x and y is block or random with x being the first or last block.

Likewise, "z" is a whole number, as it represents the number of iterations of the formula. For example, for a POₓ-EO_{y}-BOₓ oligomer, z is 2 and the second y is zero. For EO_{y}-BOₓ-POₓ- oligomer, z is 3, with the first x and the second and third y's zero.

In another embodiment mid-range alkoxylate nonionic surfactants include compounds having a general formula:

R¹-O-(CH₂CH(R²)-O)ₓ(CH₂CH₂O)_{y}-H (II)

wherein x is a real number from 1 to 11; y is a real number from 1 to 20; R¹ is C₆₋₁₀ branched or linear alcohol; and R² is -CH₃ or -CH₂CH₃.

In one embodiment x is typically 4, 5 or 6, more typically 5. In one embodiment y is typically 3, 6, 9 or 11, more typically 6. R¹ may be C₆₋₁₀ branched or linear alcohol. Typically R¹ is a C₈₋₉ branched alcohol. In one embodiment R¹ is 2-ethyl hexanol or 2-propyl hexanol, more typically 2-ethyl hexanol.

In one embodiment R¹ is an alcohol produced from internal octenes. Internal octenes refers to the unreacted residual or by product left behind when reacting ethylene with 1-octene to produce ethylene/1-octene copolymers. These internal octenes may be obtained as a purge stream from the process and then may be converted to alcohols by a process which is described hereinafter. Alcohols produced from internal octenes include at least one of 1-nonanol, 2-mewthyl-l-octanol, 2-ethyl-l-septanol, 2-propyl-l-hexanol, 3-methyl-4-hydroxymethyl septane, 3-methyl-3-hydroxymethyl-septane or 2-hydroxymethyl-3-methyl septane. Typically the alcohols are a blend depending on the source of l-octene.

In one embodiment R² is -CH₃ representing a propylene oxide. In other embodiments R² is H₂CH₃ representing a butylene oxide.

Typical surfactants of formula II are those where x is 4, 5 or 6; y is 3, 6, 9 or 11; R¹ is a C₈₋₉ branched alcohol and R² is -CH₃. Most typical surfactants of formula II are those where x is 5; y is 6; R¹ is 2-ethyl hexanol and R² is -CH₃. Typically the PO or BO portion and EO portion are the result of a block feed.

Alcohols may be converted to alcohol alkoxylates by methods such as those discussed in U.S. 2005/0170991A1. Fatty acid alcohols may also be alkoxylated using metal cyanide catalysts including, but not limited to, those described in U.S. 6,429,342.

Alkoxylation processes may be carried out in the presence of acidic or alkaline catalysts. Typically alkaline catalysts, such as hydroxides or alcoholates of sodium or potassium, including sodium hydroxide, potassium hydroxide, sodium methoxide, potassium methoxide, sodium ethoxide and potassium ethoxide are used. Base catalysts are typically used in amounts of 0.05wt% to 5wt%, more typically 0.1wt% to 1wt% based on the starting material. In one non-limiting embodiment a C8 olefin mixture is first converted to an alcohol and subsequently converted to form a nonionic surfactant via alkoxylation with from 2 to 5 moles of propylene oxide and from 1 to 10 moles of ethylene oxide.

The addition of alkylene oxides may, in one non-limiting embodiment, be carried out in an autoclave under pressure from 10 psig (pounds per square inch gauge) to 200 psig, typically from 60 psig to 100 psig. The temperature of alkoxylation may range from 30° C to 200° C, typically 100° C to 160° C. After completion of oxide feeds the product is allowed to react until the residual oxide is less than 10 ppm. After cooling the reactor to an appropriate temperature ranging from 20° C to 130° C the residual catalyst may be left unneutralized or neutralized with organic acids, such as acetic, propionic or citric acid. Alternatively the product may be neutralized with inorganic acids, such as phosphoric acid or carbon dioxide. Residual catalyst may also be removed using ion exchange or an adsorption media, such as diatamacious earth. The final mid-range alkoxylates are readily biodegradable and may be used in the cleaning solutions in amounts of 0.001wt% to 10wt%, or such as from 0.05wt% to 5wt%.

Optionally, the aqueous alkaline cleaning solutions include one or more alkoxylated glycols having a weight average molecular weight of 170 g/mole or greater and a flash point of 100° C or greater. Typically, the weight average molecular weight of the alkoxylated glycols range from 170 g/mole to 4000 g/mole, more typically from 190 g/mole to 500 g/mole. Flash points typically range from 100° C to 300° C. More typically, flash points range from 140° C to 200° C. Alkoxylated glycols used in the aqueous alkaline cleaning solutions are either watersoluble or at least water-miscible. The flash points of 100° C or greater provide non-volatile compositions preventing substantial evaporation of composition components. In addition, the alkoxylated glycols have boiling points of 190° C or greater which further reduces the amount lost at operating temperatures. Accordingly, the compositions may be used over longer periods of time than many conventional cleaning compositions.

Alkoxylated glycols are included in the aqueous composition in amounts of 0.01wt% to 2wt% of the aqueous solution. Typically, the alkoxylated glycols are included in amounts of 0.1wt% to 1wt% of the aqueous composition. The alkoxylated glycols are non-cyclic but are linear or branched compounds. Alkoxylated glycols include, but are not limited to, compounds having a general formula:

HO(CₐH₂ₐO)ₘH (III)

wherein "m" is an integer of 3 or greater, or such as from 8 to 66. Typically, m is an integer of 3 to 6, more typically from 3 to 5 and "a" is an integer of 3 to 6, or such as from 3 to 4. Examples of such alkoxylated glycols are tripropylene glycol, tetrapropylene glycol, polypropylene glycol, tributylene glycol, tetrabutylene glycol, polybutylene glycol, tripentylene glycol, tetrapentylene glycol and polypentylene glycol.

Alkoxylated glycols also include, but are not limited to, compounds having a general formula:

HO(CH₂CH₂O)ₙH (IV)

wherein "n" is an integer of 3 or greater, or such as from 5 to 200. Typically, n is an integer of 3 to 5, more typically from 3 to 4. Examples of such alkoxylated glycols are triethylene glycol, tetraethylene glycol and polyethylene glycol.

Optionally, the aqueous alkaline cleaning solutions include one or more chelating agents. Chelating agents are included in the compositions in amounts of 0.001wt% to 5wt%, or such as from 0.01wt% to 1 wt%. Such chelating agents include, but are not limited to, ethylenediamine tetraacetic acid and its salts, polycarboxylic acids and their salts. Examples of dicarboxylic acids are iminodiacetic acid, oxalic acid, malonic acid, succinic acid, glutaric acid, adipic acid, pimelic acid, maleic acid, fumaric acid and phthalic acid and their salts. Examples of tricarboxylic acids are nitrilotriacetic acid, trimellitic acid tricarballylic acid and their salts. Typically the salts of the acids are used, such as their alkali metal salts to help maintain an alkaline environment ofpH 11 and greater.

In addition to one or more mid-range alkoxylate nonionic surfactants, the aqueous alkaline cleaning and micro-etching solutions may include one or more additional surfactants which do not compromise the cleaning and micro-etching performance of the composition. Such surfactants may be conventional nonionic, anionic, cationic, amphoteric and gemini (dimeric) surfactants. Typically, the surfactants are nonionic. Such surfactants are included in the compositions in amounts of 0.001wt% to 3wt%, or such as from 0.01wt% to 1wt%.

A clean surface is important in achieving optimum appearance and efficiency of photovoltaic devices. Any contaminants on the surface of the wafer may ultimately compromise the performance of the photovoltaic devices. The alkaline cleaner removes substantially all of the metals, metal oxides and organic compounds from the wafer surface. Iron and copper are especially difficult to remove using water. Iron in particular is problematic because it forms iron oxide on the wafer surface. Once iron oxide forms on the wafer surface it is very difficult to remove and compromises the overall incident light absorbance of the wafer. Further, if substantial amounts of iron remain on the wafer surface, the black spots characteristic of iron oxide formation become worse over time. The alkaline cleaner reduces contaminants to levels in the ppb range and lower. Typically, after this aqueous alkaline cleaning and micro-etching composition is applied to the semiconductor wafer the contaminants range from 0 ppb to 10 ppb.

Optionally, the semiconductor wafer is rinsed with water. Immediately subsequent to cleaning or the rinsing step with water and prior to texturing the native oxide is restored by applying an alkaline oxidizing composition with a pH greater than 7 to the cleaned surface of the semiconductor wafer. The thickness of the native oxide may vary. Typically it ranges from 1 to 301Å. The oxidizing composition includes one or more oxidizing agents which include, but are not limited to, ozone, peroxides, such as hydrogen peroxide and urea hydrogen peroxide, perborates, such as sodium perborate (e.g., mono- or tetra-hydrate), percarbonates, such as sodium and potassium carbonate, permanganates, hypochlorites, such as sodium hypochlorite, calcium hypochlorite, potassium hypochlorite and magnesium hypochlorite, chlorites, chlorates, perchlorates, hypobromites, bromates, hypoiodates and iodates. One or more organic and inorganic peracids also may be used to restore native oxides provided that the pH of the oxidizing composition is adjusted to greater than 7. The peracids may be combined with one or more of the other oxidizing agents. Peracids include, but are not limited to, percarboxylic acids and salts, percarbonic acids and salts, perimidic acids and salts, peroxymonosulfuric acids and salts, persulfates, such as monopersulfate, peroxyacids, such as diperoxydodecanoic acid (DPDA), magnesium perphthalic acid, perlauric acid, phthaloyl amidoperoxy caproic acid (PAP), perbenzoic and alkylperbenzopic acids, and bisulfates, such as alkali metal bisulfates which include potassium bisulfate.

Typically the oxidizing compositions are aqueous based and have a pH greater than 7, more typically a pH of 8-12. Oxidizing agents included in the oxidizing composition range from 0.01wt% to 20wt%, or such as from 1wt% to 10wt% of the oxidizing composition.

Optionally the oxidizing composition may include one or more additives to stabilize the oxidizing composition and improve the texturing performance of the texturing composition. Such additives include, but are not limited to, one or more of surfactants, chelating agents and phosphonic acids.

Surfactants included in the oxidizing composition include any surfactant which is stable in the oxidizing composition. Such surfactants may include nonionic, amphoteric, cationic and anionic surfactants which are stable in the oxidizing composition. Typically non-hydroxyl containing surfactants are used. Examples of anionic non-hydroxyl containing surfactants are surfactants containing sulfonate, sulfate and phosphate functional groups. Examples of sulfonated surfactants are alkyldisulfonated diphenyl oxides, including its alkali metal salts, such as sodium mono- and di-decyldisulfonated diphenyl oxide. Examples of semi-polar nonionic surfactants which are stable in the oxidizing compositions are amine oxide surfactants. In general, surfactants are included in amounts of 0.01wt% to 5wt%, or such as from 0.5wt% to 3wt% of the oxidizing composition.

Chelating agents include, but are not limited to, ethylenediamine tetraacetic acid (EDTA), iminodiacetic acid (IDA), cyclohexane diamine tetraacetic acid (CDTA), acetic acid, acetone oxime, alanine, arginine, asparagine, aspartic acid, benzoic acid, betaine, citric acid, dimethyl glyoxime, fumaric acid glutamic acid, glutamine, glutaric acid, glycine, glycolic acid, glyoxylic acid, histadine, isophthalic acid, itaconic acid, lactic acid, leucine, lysine, maleic acid, malic acid, malonic acid, oxalic acid, 2,4-pentandione, phenylacetic acid, phenylalanine, phthalic acid, praline, pyrometallic acid, quinic acid, serine, sorbitol, succinic acid, teraphthalic acid, trimellitic acid, trimesic acid, tyrosine, valine and xylitol. Chelating agents are included in the oxidizing composition in amounts of 0.01wt% to 5wt%, or such as from 0.5wt% to 3wt%.

Phosphonic acids include, but are not limited to, ethylenediamine tetramethylenephosphonic acid, ethylenediaminedimethylene phosphonic acid, nitrilotrismethylenephosphonic acid, 1-hydroxyethylidene-1,1-diphosphonic acid and their salts. Phosphonic acids are included in the oxidizing compositions in amounts of 0.01wt% to 5wt%, or such as from 0.5wt% to 3wt%.

The oxidizing composition may be applied to the semiconductor wafer by any suitable process known in the art. The oxidizing composition may be sprayed on the wafer or the wafer may be immersed in the oxidizing composition. Dwell times for the oxidizing composition on the wafer to restore native oxide range from 3 seconds to 5 minutes, typically 30 seconds to 5 minutes. Native oxide restoration may be done at room temperature to 50° C. Typically native oxide restoration is done at room temperature to 30° C.

By providing a clean wafer surface and by restoring native oxide on the semiconductor wafer, the wafer surface is immediately ready for texturing. By restoring the native oxide by oxidizing the cleaned semiconductor substrate with an oxidizing composition, the texturing defects caused by cleaning with alkaline or acid solutions is prevented and damage to textured wafers by any handling by workers is corrected. The contact angle is restored to substantially zero and texturing is improved. The texturing is uniform and, in the case of monocrystalline substrates, pyramid formation is reproducible. While not being bound by theory, reducing the contact angle to zero allows for an even wetting of the surface during texturing resulting in a uniform and, in the case of monocrystalline substrates, reproducible pyramid surfaces. The texturing reduces incident light reflectance and improves the conversion of light energy into electrical energy in a photovoltaic device or other device which includes the wafer. In general, texturing is directed to providing a uniform surface roughness of 1 µm and greater, typically from 1µm to 10)µm.

Because the native oxide is restored prior to texturing many conventional texturing formulations may be used. Typical formulations include water, one or more alkali hydroxides, such as sodium or potassium hydroxide, and one or more alcohols or glycols. The alkali hydroxides may be included in amounts of 0.5wt% to 50wt%. Alcohols and glycols may be included in amounts of 0.001wt% to 20wt%. The balance of the texturing formulations is water. Conventional aqueous acid texturing compositions also may be used. Such acid texturing compositions include, but are not limited to 5%bv to 20%bv of 49wt% hydrofluoric acid and 10%bv to 50%bv of 65wt% nitric acid.

More typically the aqueous solutions for texturing semiconductor substrates include one or more of the alkoxylated glycols as described above. The alkoxylated glycols are included in the aqueous texturing solutions in amounts of 0.001 wt% to 2wt% of the aqueous solution. Typically, the alkoxylated glycols are included in amounts of 0.1wt% to 1wt% of the aqueous solution.

Alkaline compounds included in the texturing compositions in combination with the alkoxylated glycols include, but are not limited to, alkali metal hydroxides, such as potassium, sodium hydroxide and lithium hydroxide, and quaternary ammonium hydroxides, such as tetramethyl ammonium hydroxide, tetrapropyl ammonium hydroxide, tetrabutyl ammonium hydroxide, tetramethyl-2-hydroxylethyl ammonium hydroxide (choline), trimethyl-3-hydroxypropyl ammonium hydroxide, trimethyl-3-hydroxybutyl ammonium hydroxide, trimethyl-4-hydroxybutyl ammonium hydroxide, tritriethyl-2-hydroxylethyl ammonium hydroxide, tripropyl-2-hydroxyethyl ammonium hydroxide, tributyl-2-hydroxylethyl ammonium hydroxide, dimethylethyl-2-hydroxyethyl ammonium hydroxide, dimethyldi(2-hydroxyethyl ammonium hydroxide, monomethyltri(2-hydroxyethyl) ammonium hydroxide, monomethyltriethyl ammonium hydroxide, monomethyltripropyl ammonium hydroxide, monomethyltributyl ammonium hydroxide, monoethyltrimethyl ammonium hydroxide, monoethyltributyl ammonium hydroxide, dimethyldiethyl ammonium hydroxide and dimethyldibutyl ammonium hydroxide.

Other alkaline components which may be included with the alkoxylated glycols include ammonium hydroxide, alkanolamines such as 2-aminoethanol (monoethanolamine), 1-amino-2-propanol, 1-amino-3-propanol, 2-(2-amino-ethoxy)ethanol, 2-(2-aminoethylamino)ethanol. Other suitable alkaline compounds include 3-methoxypropylamine, morpholine, alkane diamines, such as 1,3-pentanedaimine and 2-methyl-1,5-pentanediamine, and guanidine.

Typically the alkaline compound included in the aqueous texturing solution in combination with the alkoxylated glycols is chosen from one or more hydroxides. More typically, the alkaline compound is chosen from one or more alkali metal hydroxides and alkyl ammonium hydroxides. Alkaline compounds are included in the aqueous texturing solutions in amounts of 0.5wt% to 15wt% of the aqueous solution. Typically, the alkaline compound is included in the aqueous texturing solution in amounts of 1wt% to 10wt%.

Optionally, the aqueous texturing solution may include one or more alkali metal chlorides, such as sodium and potassium chloride and one or more silicates, such as alkali metal silicates, such as the sodium and potassium silicates. Mixture of metal chlorides and metal silicates may be used. Such metal chlorides and metal silicates may be included in the aqueous solutions in amount of 0.01wt% to 2wt%, or such as from 0.5wt% to 1wt% of the aqueous solution.

In one embodiment the aqueous texturing solution consists essentially of one or more alkoxylated glycols having a weight average molecular weight of 170 g/mole or greater and a flash point of 100° C or greater, one or more alkaline compounds and water. In another embodiment, the aqueous texturing solution consists essentially of one or more alkoxylated glycols having a weight average molecular weight of 170 g/mole or greater and a flash point of 100° C or greater, one or more alkaline compounds, one or more compounds chosen from alkali metal chlorides and alkali metal silicates and water.

In general texturing solutions may be applied to a surface of a semiconductor substrate by any suitable method known in the art. The texturing solutions are applied to a surface of the semiconductor substrate at temperatures of 70° C or higher, typically from 80° C to 200° C, or such as from 90° C to 150° C. Typically, texturing solutions are applied to a surface of the semiconductor substrate by horizontal or vertical processes. Such methods are well known in the art. Briefly, horizontal methods involve passing the semiconductor substrate on a conveyor system and spraying the aqueous solution on the surface of the substrate. In the vertical process the substrate is dipped in the texturing solution. Various conventional apparatus used for such processes are well known in the art.

In general, the texturing method for monocrystalline wafers is anisotropic and forms uniform and repeatable pyramid (tetragonal) structures over the entire treated surface of the semiconductor substrate. The pyramid structures are randomly dispersed over the entire treated surface. The pyramid structures may range in height from 1 µm to 10µm. In the case of multicrystalline wafers the texturing is isotropic and a scalloped surface is formed instead of pyramid structures.

The semiconductors textured with the methods reduce reflectance from incident light applied to their textured surfaces. Reflectance of incident light in the 360nm to 1000nm wavelength range is typically 14% or less, more typically 12% to 14%. Reflectance may be measured using conventional reflectometers well known in the art. Accordingly, semiconductors textured by the method using the aqueous solutions are suitable for use in devices which convert incident light, such as light from sunlight, lasers, fluorescent light, as well as other sources of light, into electric energy. Such devices include, but are not limited to photovoltaic devices, such as solar cells, optical and electrochemical detectors/sensors, biodetectors/biosensors, catalysts, electrodes, gate electrodes, ohmic contacts, interconnection lines, Schottky barrier diode contacts and optoelectronic components.

The surfaces of the semiconductors textured with the aqueous solutions described above provide semiconductors which reduce the reflectance of incident light in contrast to many conventional methods of texturing. This increases the amount of incident light absorbed by the semiconductor and improves the efficiency of converting light into electrical energy.

The following examples are included to illustrate the invention but are not intended to limit the scope of the invention.

### Examples 1-4

Four aqueous cleaning solutions were prepared as shown in Table 1 below.

**Table 1**

| **Example** | **Component** | **Amount** |
|---|---|---|
| 1 | Alky polyglycoside¹ | 20wt% |
| 2 | Oxalic acid | 20wt% |
| 3 | Hydrofluoric acid | 2wt% |
| 4 | Potassium hydroxide | 2wt% |
| | Sodium carbonate | 2wt% |
| | ALky polyglycoside¹ | 0.2wt% |

| | | |
|---|---|---|
| ¹alkyl polyglycoside with alkyl groups of 8 to 16 carbon atoms with an average degree of polymerization of 1.6 6 (Glucopon® 425N) | | |

Eight monocrystalline silicon wafers were cut from ingots using a conventional wire saw. Slurries used in the cutting process were a mixture of silicon carbide and polyethylene glycol in a mixture of base:silicon carbide of 0.8 to 0.9:1. The cutting process resulted in many contaminants on the surface of the wafers: metals from the wire saw, such as iron, iron oxide, copper, copper oxide and zinc, as well as the polyethylene glycol and silicon carbide particles from the slurries. Five of the eight wafers were cleaned with the alkaline etch cleaner which included the potassium hydroxide, sodium carbonate and alkyl polyglycoside. The remaining wafers were cleaned with one of the neutral cleaner (non-etch), which included alkyl polyglycoside and water, the hydrofluoric acid etch cleaner or the oxalic acid cleaner (non-acid etch).

The wafers were immersed in the aqueous cleaning solutions with ultrasonics at 50° C with dwell times of 10 minutes. After cleaning four of the wafers cleaned with the alkaline cleaner were rinsed for 15 seconds as room temperature. One was rinsed with a 20wt% oxalic acid rinse, one was rinsed with hot water at 30° C and another was rinsed with cold water at 10° C. The fourth was rinsed with an oxidizing solution with a pH greater than 7 for restoring native oxide having the formula disclosed in Table 2 below. Rinsing was done for 15 seconds. The remaining wafers were not rinsed.

**Table 2**

| **COMPONENT** | **AMOUNT** |
|---|---|
| Sodium hypochlorite | 10wt% |
| Hydrogen peroxide | 10wt% |
| Sodium percarbonate | 10wt% |
| Sodium perborate | 10wt% |
| Diphenyl oxide disulfonate | 2wt% |
| Water | Balance |

After the wafers were cleaned their cleanliness was determined by visual uniformity of the wafer surfaces and by a conventional metal analysis test. The cleaning results are recorded in Table 4 below. The wafers cleaned with the alkaline cleaner did not show any contamination. In contrast the wafers cleaned with the acid cleaners and the neutral cleaner still had unacceptable amounts of contamination. The contact angles of each of the wafers cleaned with the neutral cleaner, the hydrofluoric acid cleaner and the alkaline cleaners were measured using ASTM method ASTM D7334-08. The contact angle for the wafer cleaned with the neutral cleaner and the alkaline cleaner where the oxidizing rinse was used was 0. The contact angle for the wafer cleaned with the hydrofluoric acid was 75 degrees and the contact angle for the remainder of the wafers cleaned with the alkaline cleaner was 65 degrees.

Each wafer was then etched to form pyramid structures using the texturing composition disclosed in Table 3 below.

**Table 3**

| **COMPONENT** | **AMOUNT** |
|---|---|
| Sodium hydroxide | 50wt% |
| Isopropyl alcohol | 600 ml |
| Dissolved silicates | 400 ml |

Each wafer was immersed in the texturing solution for 5 minutes at 60° C. After texturing the amount of silicon removed from each wafer was determined and the quality of the pyramid formation was examined. The amount of silicon removed from each wafer was determined by weighing each wafer before texturing and after texturing and taking the difference between the weights. The silicon removed from each wafer is shown in Table 4 below. The surface of each wafer was examined using a scanning electron microscope (AMRAY 1510 Field Emission scanning electron microscope). Reflectance was also determined. Reflectance of the textured surface was taken using a MacBeth Coloreye Reflectometer 7000 in the wavelength range of 360nm to 750nm. The source of the incident light was a pulsed xenon bulb. An average of 6 reflectance readings was taken across the surface. The results are disclosed in Table 4 below.

**Table 4**

| **Cleaning Process** | **Pre-Texture Rinse** | **Silicon Removal (average per side)** | **Reflectance (average)** | **Pyramid Structure** | **Cleanliness** |
|---|---|---|---|---|---|
| Neutral | None | 7 microns | 14% | Uniform medium | No metal removal |
| Non Etch Acid | None | 7-8 microns | 15% | Uniform and large | Organic slurry not removed |
| Etching Acid | None | 2-3 microns | 25% | Non-uniform and small | Metals and organic residue |
| Alkaline | None | 4 microns | 20% | Non-unifonn and small | Clean |
| Alkaline | Acid | 4 microns | 20% | Non-uniform and small | Clean |
| Alkaline | Cold water | 4 microns | 20% | Non-uniform and small | Clean |
| Alkaline | Hot water | 4 microns | 20% | Non-uniform and small | Clean |
| Alkaline | Oxidizing | 7 microns | 14% | Uniform and medium | Clean |

The wafers with the small pyramid structures had peak heights in the 1µm to 3µm range but were not uniform over the surface of the wafer. The wafers with the medium pyramid structures had peak heights in the range of 6 µm to 8µm with minor amounts in the 1µm to 3µm range. The pyramid structures were uniform in appearance over the surface of the wafer.

The results showed poor texturing for those wafers which were not treated with the oxidizing composition after cleaning with the exception of the neutral cleaning solution which retained its native oxide during cleaning. Although the native oxide was not removed by the cleaning action of the neutral cleaner and good texturing was achieved, the neutral cleaner failed to clean contaminants. The native oxide was restored on the cleaned wafer rinsed with the oxidizing composition, thus good texturing resulted. In addition the presence of native oxide reduced the contact angle which contributed to the improvement of the pyramid formation. The remaining cleaning solutions removed all or at least sufficient amounts of the native oxide such that poor texturing or pyramid formation resulted. The test used to determine if the native oxide was removed or not was done by determining the contact angle of the wafer. If the native oxide was present, the wafer was hydrophilic and the contact angle was 0 degrees. If the native oxide was removed, the wafer was hydrophobic and the contact angle was greater than 0 degrees. In addition smaller peaks were achieved with texturing for wafers where the native oxide is removed in contrast to wafers with native oxide.

Reflectance was also compromised by those wafers which had poor texturing or pyramid formation. The average reflectance for the wafers cleaned with the neutral cleaner without a pretexturing rinse and the wafer rinsed with the oxidizing composition was 14%. Although the wafer cleaned with the neutral cleaner had comparable reflectance with the wafer rinsed with the oxidizing composition, the cleaner failed to remove contaminants. The remainder of the wafers had poor average reflectance values of from 15% to 25%. Accordingly, only those wafers which had native oxide during texturing resulted in wafers with good pyramid formation and reflectance values.

### Example 5

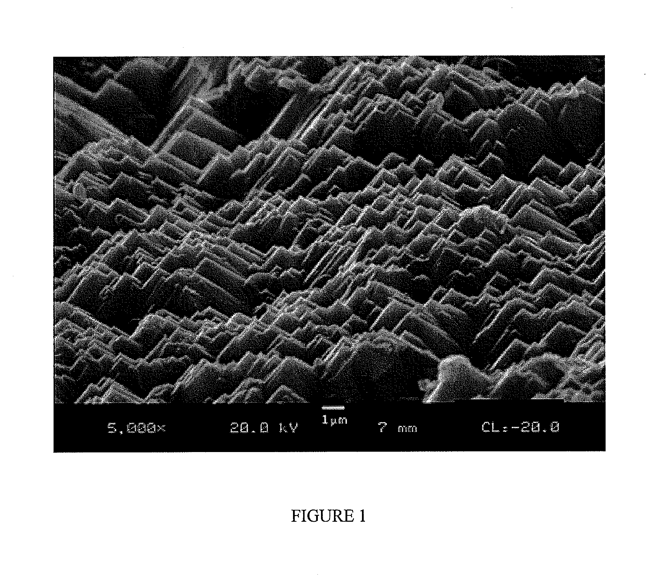

A plurality of monocrystalline silicon wafers were cleaned with the alkaline cleaning formulation and method of Example 4. After cleaning the wafers were handled by workers wearing safety gloves to protect their hands from the alkaline cleaning solution. The wafers were than immersed in the texturing composition used in Examples 1-4 and under the same conditions. After texturing the wafers were placed under the scanning electron microscope described above and SEMs were taken of the pyramid structures formed on the wafers. All showed poor pyramid formation. In addition some damage where the workers fingers came in contact with the wafers was noticed. Figure 1 shows the poor texturing and finger damage of one of these wafers.

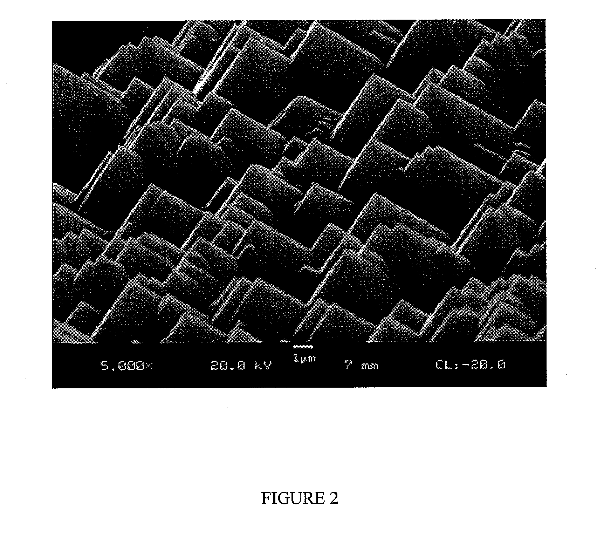

The wafers were then rinsed with the oxidizing composition described in Examples 1-4 under the same rinsing conditions. The wafers were then re-textured and their surfaces were examined for the quality of the pyramid structures using the electron microscope. Figure 2 is a SEM of one of the wafers treated with the oxidizing composition and then textured. Figure 2 shows improved pyramid formation in contrast to that of Figure 1. Rinsing of the damaged wafers with the oxidizing composition restored the native oxide on the wafer surfaces. This allowed re-texturing and correction of the damage caused by worker handling.

### Example 6

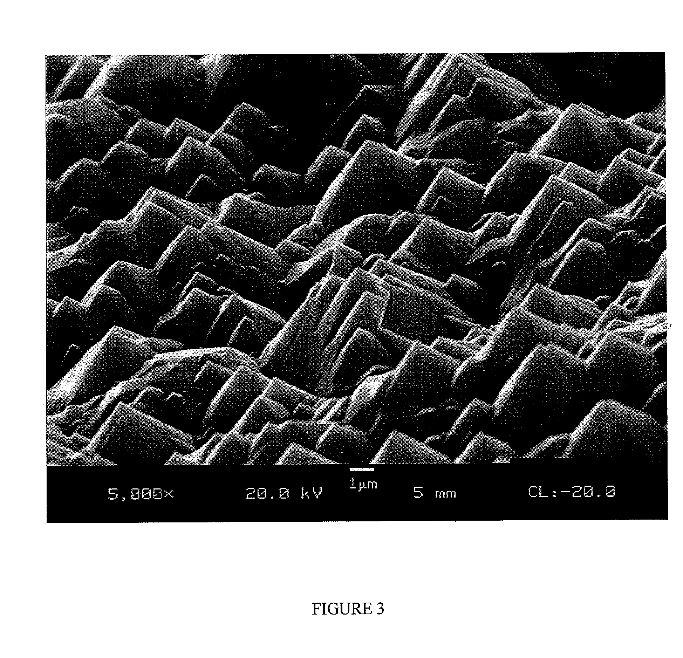

An aqueous alkaline cleaning formulation which included 0.5wt% tetramethyl ammonium hydroxide, 0.4wt% potassium hydroxide, 0.12wt% sodium salt of a polycarboxylic acid chelating agent, 0.05wt% alcohol alkoxylate surfactant and 0.25wt% tripropylene glycol was prepared and then diluted with water to 5%bv. A monocrystalline wafer was cleaned with the aqueous alkaline cleaner for one min. at 55° C. The wafer contact angle was determined to be 30-40°. After cleaning the wafer was immersed in an aqueous oxidizing composition for 60 seconds at 55° C to restore the native oxide removed from the wafer during cleaning. The aqueous oxidizing composition included 3 g/L hydrogen peroxide at a pH =1.1. The wafer contact angle was determined to be 30-40°. The wafer was then textured with an aqueous alkaline solution containing 60 g/L of potassium hydroxide and 0.6%bv of tripropylene glycol for 30 min. at 80° C. After texturing the wafer was placed under the scanning electron microscope and a SEM was taken of the pyramid structures formed on the wafer. The loss of silicon due to texturing was determined to be 7.6%. Figure 3 is the SEM taken of the pyramid structures formed. The average incident light reflectance of the wafer after texturing was determined to be 14.4%.

### Example 7

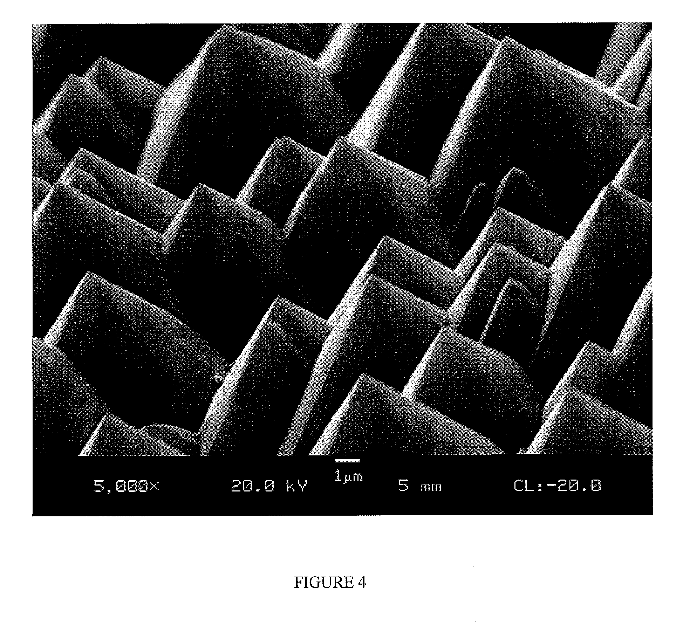

A monocrystalline silicon wafer was cleaned with the aqueous alkaline cleaner of Example 6 under the same conditions. After the wafer was cleaned the native oxide was restored with an aqueous alkaline oxidizing composition which included 3g/L hydrogen peroxide at a pH = 12.8. Oxidation was done for 60 seconds at 20° C. The wafer contact angle was determined to be 0°. The wafer was then textured with the same aqueous alkaline solution and for the same amount of time and at the same temperature as the wafer in Example 6. The loss of silicon due to texturing was determined to be 10.1 %. Figure 4 is a SEM of the wafer after texturing. In comparison to the pyramid structures of Figure 3, the pyramid structures of Figure 4 appear more uniform. In addition, the average incident light reflectance of the wafer was determined to be 13.3% which was an improvement over that of the wafer in Example 6.

## Claims

1. A method comprising:
a) cleaning a semiconductor substrate with an alkaline or acid silicon etching solution;
b) oxidizing a surface of the cleaned semiconductor substrate with an oxidizing composition comprising one or more oxidizing agents, the oxidizing composition has a pH greater than 7; and
c) texturing the oxidized semiconductor substrate.

2. The method of claim 1, wherein the one or more oxidizing agents are chosen from ozone, peroxides, perborates, percarbonates, hypochlorites, chlorates, perchlorates, hypobromites, bromates, hypoiodates, iodates, organic peracids and their salts, inorganic peracids and their salts.

3. The method of claim 1, wherein the oxidizing composition further comprises one or more chelating agents.

4. The method of claim 1, wherein the oxidizing composition further comprises one or more non-hydroxyl containing surfactants.

5. The method of claim 1, wherein the oxidizing composition further comprises one or more phosphonic acids.

6. The method of claim 1, wherein the texturing composition is an alkaline composition or an acid composition.

7. The method of claim 6, wherein the alkaline texturing composition comprises one or more quaternary ammonium hydroxides.

8. The method of claim 6, wherein the alkaline texturing composition comprises one or more alkoxylated glycols.

9. The method of claim 1, wherein the alkaline cleaning solution comprises one or more hydroxides.

10. The method of claim 9, wherein the alkaline cleaning solution further comprises one or more mid-range alkoxylates.
